# EUROPÄISCHE PATENTSCHRIFT

(11) **EP 3 392 913 B1**
(45) Veröffentlichungstag und Bekanntmachung des Hinweises auf die Patenterteilung: **03.06.2020**
(21) Anmeldenummer: 18167874.9
(22) Anmeldetag: 18.04.2018
(51) Int. Cl.: H01L 31/0224, H01L 31/0352, H01L 31/0749

(54) **OPTOELEKTRONISCHES BAUTEIL**
OPTOELECTRONIC COMPONENT
COMPOSANT OPTOÉLECTRONIQUE

(30) Priorität: 21.04.2017 AT 503242017
(43) Veröffentlichungstag der Anmeldung: 24.10.2018
(73) Patentinhaber: AIT Austrian Institute of Technology GmbH, 1210 Wien (AT)
(72) Erfinder: DIMOPOULOS, Theodoros, 3423 Wördern (AT); EDINGER, Stefan, 2241 Reyersdorf (AT); BANSAL, Neha, 1090 Wien (AT)
(74) Vertreter: Gibler & Poth Patentanwälte KG

(56) Entgegenhaltungen:
- DE-A1-102014 224 004
- US-A1- 2010 276 003
- US-A1- 2011 186 124
- US-A1- 2011 186 125
- US-A1- 2014 224 321

## Beschreibung

Die Erfindung betrifft ein optoelektronisches Bauteil gemäß dem Oberbegriff des Patentanspruches 1.

Es sind optoelektronische Bauteile bekannt, welche einen transparenten Frontkontakt aufweisen. Der transparente Frontkontakt ist eine transparente und elektrisch leitfähige Beschichtung auf einer Oberfläche des optoelektronischen Bauteils und Teil des optoelektronischen Bauteils. Aufgabe des transparenten Frontkontakts ist es Licht zu den fotoaktiven Bereichen des optoelektronischen Bauteils gelangen kann, beispielsweise zu dem Absorber bei einer Solarzelle, zu lassen, und andererseits Ladungsträger aus oder zu den fotoaktiven Bereichen zu transportieren. Insbesondere bei großflächigen optoelektronische Bauteilen wie Solarzellen kommt dem transparenten Frontkontakt eine besonders große Bedeutung zu. Qualitative Mängel des transparenten Frontkontakts können den Wirkungsgrad und die Lebensdauer der Solarzellen erheblich beinträchtigen. Weiters beeinflusst die Bandstruktur der verwendeten Materialien stark den Wirkungsgrad. Auf der anderen Seite sollte der transparente Frontkontakt großflächig und wirtschaftlich herstellbar sein.

Es sind als Solarzellen ausgebildete optoelektronische Bauteile bekannt, bei welchem auf dem Absorber eine Pufferschicht angeordnet ist, auf der Pufferschicht eine Fensterschicht aus undotiertem Zinkoxid, und auf der Fensterschicht eine hochleitfähige Schicht aus Aluminium-Zinkoxid, auch AZO genannt, oder Indium-Zinnoxid, auch ITO genannt. Der Absorber und die Pufferschicht bilden den pn-Übergang. Die Fensterschicht hat eine vergleichsweisen hohen Widerstand und muss die Pufferschicht komplett überdecken, damit ein direkter Kontakt der hochleitfähigen Schicht mit der Pufferschicht verhindert, und dadurch der Shuntwiderstand der Solarzelle hoch gehalten werden kann. Weiters muss eine herkömmliche Fensterschicht eine geringe Defektdichte, eine homogene und kompakte Struktur sowie eine gewisse Anpassung der Energieniveaus an die Bänderstruktur der Pufferschicht aufweisen, damit die Zahl der ungewollten Ladungsträgerrekombinationen gering bleibt. Aufgrund dieser hohen Anforderungen wird die Fensterschicht als Sputterschicht, daher mittels Magnetron-Kathodenzerstäubung abgeschiedene Schicht, hergestellt.

Nachteilig daran ist, dass die für die Herstellung des transparenten Frontkontakts des optoelektronischen Bauteils notwendigen Beschichtungsmethoden wie Magnetron-Kathodenzerstäubung oder andere qualitativ hochwertige Gasphasenabscheidungsverfahren einen hohen apparativen Aufwand erfordern, insbesondere wenn Vakuumanlagen benötigt werden. Gerade bei großflächigen optoelektronischen Bauteilen wie Solarzellen stellt die Herstellung des transparenten Frontkontakts einen erheblichen Kostenfaktor dar. Hierbei ist eine hohe Qualität der Schichten des transparenten Frontkontakts wichtig, da Fehler in den Schichten, beispielsweise eine hohe Defektdichte oder Inhomogenitäten in der Struktur, die Qualität des optoelektronischen Bauteils erheblich verringern. Weiters ergeben sich wesentliche Probleme mit den bisher verwendeten Beschichtungsmethoden, wenn der Untergrund für den transparenten Frontkontakt stark uneben ist, beispielsweise bei einer Monokornmembran Solarzelle, da dadurch bei üblichen physikalischen Gasphasenabscheidungsverfahren die Eigenschaften der auf einem unebenen Untergrund abgeschiedenen Schichten örtlich stark variiert.

Die US 2010/276003 A1 offenbart ein optoelektronisches Bauteil mit einem transparenten Frontkontakt, wobei eine Metalloxidschicht mittels eines Badabscheidungsverfahrens auf einer Nanopartikelschicht aufgetragen ist.

Die US 2011/186124 A1 offenbart ein optoelektronisches Bauteil. Auf eine Schicht aus Nanopartikeln können mittels eines flüssigkeitsbasierenden Abscheideverfahrens eine erste und eine zweite Zinkoxidschicht aufgetragen werden.

Die US 2011/186125 A1 offenbart ein optoelektronisches Bauteil. Eine elektrisch leitfähige Zinkoxidschicht wird mittels eines CBD Verfahrens auf einer nicht leitenden Schicht aufgebracht.

Die US 2014/224321 A1 offenbart eine Solarzelle, die aus mehreren Schichten besteht. Eine Frontelektrodenschicht besteht hauptsächlich aus Aluminiumdotiertem Zinkoxid und wird auf eine Unterschicht laminiert.

Die DE 10 2014 224004 A1 offenbart eine Solarzelle mit einer Monokornmembran, die als Absorptionsschicht dient.

Aufgabe der Erfindung ist es daher ein optoelektronisches Bauteil der eingangs genannten Art anzugeben, mit welchem die genannten Nachteile vermieden werden können, welches eine hohe Qualität hat aber dennoch besonders schnell und einfach herzustellen ist.

Erfindungsgemäß wird dies durch die Merkmale des Patentanspruches 1 erreicht.

Dadurch ergibt sich der Vorteil, dass das optoelektronische Bauteil wesentlich einfacher herzustellen ist und dennoch ein qualitativ hochwertiger transparenter Frontkontakt hergestellt werden kann. Im Gegensatz zu herkömmlichen Beschichtungen können die Nanopartikelschicht und die Badabscheidungsschicht aus Flüssigkeiten abgeschieden werden, wodurch keine aufwendigen Vakuumanlagen oder andere aufwendigen Apparaturen für Gasphasenabscheidungsverfahren notwendig sind. Dadurch wird der Herstellungsaufwand erheblich reduziert, insbesondere bei einer kontinuierlichen Herstellung in einem Rolle-zu-Rolle Prozess. Weiters ermöglichen die Beschichtungsverfahren für die Badabscheidungsschicht wesentlich höhere Schichtwachstumsraten als herkömmliche Beschichtungsprozesse. Interessanterweise hat sich gezeigt, dass durch die Nanopartikelschicht mit der darauf angeordneten Badabscheidungsschicht ähnlich gute, teilweise sogar bessere, Wirkungsgrade bei als Solarzelle ausgebildeten optoelektronischen Bauteilen erzielt werden können, als bei herkömmlichen Sputterschichten, obwohl die Nanopartikelschicht Inhomogenitäten in der Schichtdicke aufweisen kann. Die Nanopartikelschicht bildet hierbei eine gut haftende und defektarme Grenzschicht zwischen einem Untergrund, beispielsweise einer Pufferschicht, und der Badabscheidungsschicht aus, wobei etwaige Unregelmäßigkeiten der Nanopartikelschicht, insbesondere etwaige Durchbrechungen in einer Größenordnung von bis zu einigen zehn Nanometer, zuverlässig durch die Badabscheidungsschicht ausgefüllt werden können. Weiters entfällt das bei einem Sputterprozess übliche Bombardement des Untergrunds mit hochenergetischen Teilchen, welche zu Defekten führen können. Dadurch ergeben sich insgesamt gute elektrische, optische und mechanische Eigenschaften für den transparenten Frontkontakt.

Weiters betrifft die Erfindung ein Verfahren zum Herstellen eines optoelektronischen Bauteils gemäß dem Patentanspruch 11.

Aufgabe der Erfindung ist es daher weiters Verfahren zum Herstellen eines optoelektronischen Bauteils der eingangs genannten Art anzugeben, mit welchem die genannten Nachteile vermieden werden können, und mit welchem ein optoelektronisches Bauteil hoher Qualität besonders einfach herzustellen ist. Erfindungsgemäß wird dies durch die Merkmale des Patentanspruches 11 erreicht. Die Vorteile des Verfahrens entsprechen den Vorteilen des optoelektronischen Bauteils.

Die Unteransprüche betreffen weitere vorteilhafte Ausgestaltungen der Erfindung. Ausdrücklich wird hiermit auf den Wortlaut der Patentansprüche Bezug genommen, wodurch die Ansprüche an dieser Stelle durch Bezugnahme in die Beschreibung eingefügt sind und als wörtlich wiedergegeben gelten.

Die Erfindung wird unter Bezugnahme auf die beigeschlossenen Zeichnungen, in welchen lediglich bevorzugte Ausführungsformen beispielhaft dargestellt sind, näher beschrieben. Dabei zeigt:
Fig. 1 eine erste bevorzugte Ausführungsform eines optoelektronischen Bauteils als Prinzipskizze im Schnitt; und
Fig. 2 eine zweite bevorzugte Ausführungsform eines optoelektronischen Bauteils als Prinzipskizze im Schnitt.

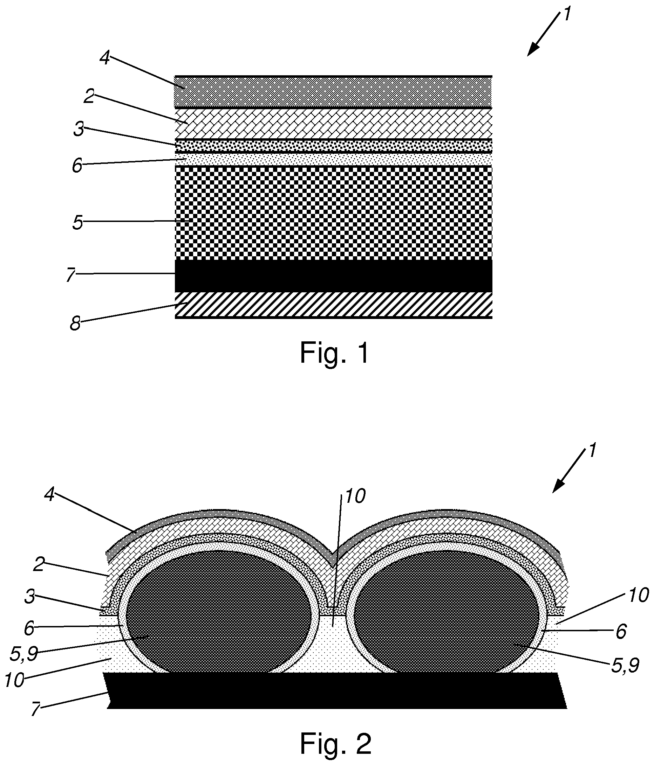

Die Fig. 1 und 2 zeigen bevorzugte Ausführungsformen eines optoelektronischen Bauteils 1 mit einem transparenten Frontkontakt. Ein optoelektronisches Bauteil 1 ist ein elektronisches Bauteil auf dem Gebiet der Optoelektronik, also jenem Gebiet der Elektronik, das sich mit Anwendungen der Wechselwirkung zwischen Licht, einschließlich der IR- und der UV-Strahlung, und elektrischen Ladungsträgern befasst. Der transparente Frontkontakt ist jener, insbesondere flächige, elektrische Kontakt des optoelektronischen Bauteils 1, welcher lichtdurchlässig und leitfähig ist. Der transparente Frontkontakt ist ein Teil des optoelektronischen Bauteils 1.

Das optoelektronische Bauteil 1 kann besonders bevorzugt eine Solarzelle sein.

Alternativ kann das optoelektronische Bauteil 1 ein Bildschirm, insbesondere Flachbildschirm, Lichtsensor, Photosensor, Leuchtdiode und dergleichen sein, da ein leichter herstellbarer Frontkontakt auch für diese optoelektronische Bauteile 1 von Vorteil ist.

Vorgesehen ist, dass der transparente Frontkontakt eine Badabscheidungsschicht 2 und eine, an der Badabscheidungsschicht 2 unmittelbar angrenzende Nanopartikelschicht 3 aufweist.

Die Nanopartikelschicht 3 ist eine Schicht, welche vorwiegend aus, insbesondere gleichartigen, Nanopartikeln besteht. Die einzelnen Nanopartikel bilden hierbei zusammen eine im Wesentlichen geschlossene Schicht aus, wobei insbesondere die einzelnen Nanopartikel die einzelnen Körner der Nanopartikelschicht 3 ausbilden. Durch diesen Aufbau aus einzelnen Nanopartikel ergibt sich ein charakteristischer Aufbau der Schicht, welcher durch herkömmliche materialwissenschaftliche Untersuchungsmethoden wie die Elektronenmikroskopie von anderen Schichten, beispielsweise Sputterschichten, unterschieden werden kann.

Die Nanopartikelschicht 3 muss weiters nicht zwingend kontinuierlich sein, also den gesamten Untergrund bedecken. Insbesondere kann die Nanopartikelschicht 3 diskontinuierlich sein, daher Durchbrechungen in der Größenordnung von einigen zehn Nanometer aufweisen.

Weiters kann vorgesehen sein, dass die Nanopartikelschicht 3 eine unregelmäßige Schichtdicke aufweist. Die Schichtdicke der Nanopartikelschicht 3 kann insbesondere 20 bis 50 nm betragen.

Die Nanopartikelschicht 3 kann insbesondere aus einem Halbleiter ausgebildet sein, besonders bevorzugt einem Halbleiter mit großer Bandlücke. Weiters kann vorgesehen sein, dass die Nanopartikelschicht 3 einen vergleichsweise hohen elektrischen Widerstand aufweist.

Die Badabscheidungsschicht 2 ist eine Schicht, welche mittels eines Badabscheidungsverfahren erzeugt wird. Als Badabscheidungsverfahren kann insbesondere chemische Badabscheidung, welche ohne zusätzliches elektrisches Feld erfolgt, oder elektrochemische Badabscheidung zur Anwendung kommen. Die Badabscheidungsschicht 2 wird unmittelbar auf der Nanopartikelschicht 3 abgeschieden. Hierbei bildet die Nanopartikelschicht 3 eine Seeding-Schicht für die aufwachsende Badabscheidungsschicht 2 dar. Die Nanopartikelschicht 3 könnte daher auch als ein flächiger Kristallisationsuntergrund für die Badabscheidungsschicht 2 bezeichnet werden. Die Badabscheidungsschicht 2 ist insbesondere kompakter als die Nanopartikelschicht 3. Weiters kann die Badabscheidungsschicht 2 etwaige Durchbrechungen in der Nanopartikelschicht 3 ausfüllen, so dass die Nanopartikelschicht 3 zusammen mit der Badabscheidungsschicht 2 eine kompakte und den gesamten Untergrund bedeckende Schicht ausbildet. Die Badabscheidungsschicht 2 übernimmt zusammen mit der Nanopartikelschicht 3 die Aufgaben der herkömmlichen Fensterschicht. Die Nanopartikelschicht 3 alleine wäre zu unregelmäßig, wodurch der Shuntwiderstand des optoelektronischen Bauteils 1 verringert werden würde.

Die Badabscheidungsschicht 2 kann insbesondere mittels chemischer Badabscheidung, auch als Chemical Bath Deposition CBD bekannt, hergestellt werden. Die chemische Badabscheidung ist eine Beschichtungstechnik zur Abscheidung dünner Schichten aus schwer löslichen Salzen aus einer Lösung. Für die Beschichtung wird der zu beschichtende Körper in ein Bad eingetaucht, wobei aus dem Bad die Salze auf den Körper abgeschieden werden. Die Abscheidung dünner Schichten erfolgt hierbei ohne einem äußeren elektrischen Feld durch die Konzentration der gelösten Stoffe, der Temperatur und der chemischen Beschaffenheit des Substrats. Mittels chemischer Badabscheidung kann daher ein Schichtwachstum auch auf einem nicht leitenden Substrat erfolgen.

Die Badabscheidungsschicht 2 kann weiters mittels elektrochemischer Badabscheidung, kurz ECD, hergestellt werden. Hierbei wird das Schichtwachstum durch das Anlegen eines elektrischen Feldes unterstützt. Die elektrochemische Badabscheidung kann insbesondere Elektroplattieren sein.

Die Badabscheidungsschicht 2 kann insbesondere aus einem Halbleiter ausgebildet sein. Die Badabscheidungsschicht 2 kann einen geringeren elektrischen Widerstand aufweisen als die Nanopartikelschicht 3. Der elektrische Widerstand der Badabscheidungsschicht 2 kann aber höher sein als jener von transparenten, leitfähigen Oxide wie AZO, damit es bei einer etwaigen Durchbrechung der Nanopartikelschicht 3 nicht zu einer starken Reduktion des Shuntwiderstandes kommt. Der Shuntwiderstand kann auch als Nebenschlusswiderstand bezeichnet werden.

Weiters ist ein Verfahren zum Herstellen des optoelektronischen Bauteils 1 vorgesehen, wobei zur Herstellung des transparenten Frontkontaktes des optoelektronischen Bauteils 1 in einem Nanopartikelschichtherstellungsschritt eine Dispersion umfassend Nanopartikel und Lösungsmittel aufgetragen wird, wobei die Nanopartikel nach einem Verflüchtigen des Lösungsmittels die Nanopartikelschicht 3 ausbilden, wobei in einem Badabscheidungsschritt auf die Nanopartikelschicht 3 mittels eines Badabscheidungsverfahrens eine Badabscheidungsschicht 2 aufgetragen wird.

In der Nanopartikelschichtherstellungsschritt wird die Nanopartikelschicht 3 hergestellt. Die Herstellung erfolgt durch das Aufbringen der Dispersion umfassend die Nanopartikel und das Lösungsmittel auf weitere Bestandteile des optoelektronischen Bauteils 1, insbesondere der Pufferschicht 6 einer Solarzelle. In der Dispersion sind die Nanopartikel als Festkörper bereits vorhanden. Nach dem Verflüchtigen des Lösungsmittels bilden die Nanopartikel eine im Wesentlichen zusammenhängende Schicht aus. Bevorzugt kann vorgesehen sein, dass die Dispersion frei von Bindemittel ist. Insbesondere kann vorgesehen sein, dass sich die Nanopartikel der Nanopartikelschicht 3 einander großflächig berühren, also im Wesentlichen keine Trennschichten zwischen den Nanopartikel vorhanden sind.

In dem Badabscheidungsschritt, welcher dem Nanopartikelschichtherstellungsschritt folgt, wird auf der Nanopartikelschicht 3 mittels eines Badabscheidungsverfahrens, insbesondere chemische Badabscheidung CBD oder elektrochemische Badabscheidung ECD, die Badabscheidungsschicht 2 abgeschieden. Eine Schichtwachstumsrate des Badabscheidungsverfahrens kann insbesondere größer als 50nm/min sein.

Dadurch ergibt sich der Vorteil, dass das optoelektronische Bauteil 1 wesentlich einfacher herzustellen ist und dennoch ein qualitativ hochwertiger transparenter Frontkontakt hergestellt werden kann. Im Gegensatz zu herkömmlichen Beschichtungen können die Nanopartikelschicht 3 und die Badabscheidungsschicht 2 aus Flüssigkeiten abgeschieden werden, wodurch keine aufwendigen Vakuumanlagen oder andere aufwendigen Apparaturen für Gasphasenabscheidungsverfahren notwendig sind. Dadurch wird der Herstellungsaufwand erheblich reduziert, insbesondere bei einer kontinuierlichen Herstellung in einem Rolle-zu-Rolle Prozess. Weiters ermöglichen die Beschichtungsverfahren für die Badabscheidungsschicht 2 wesentlich höhere Schichtwachstumsraten als herkömmliche Beschichtungsprozesse. Interessanterweise hat sich gezeigt, dass durch die Nanopartikelschicht 3 mit der darauf angeordneten Badabscheidungsschicht 2 ähnlich gute, teilweise sogar bessere, Wirkungsgrade bei als Solarzelle ausgebildeten optoelektronischen Bauteilen erzielt werden können, als bei herkömmlichen Sputterschichten, obwohl die Nanopartikelschicht 3 Inhomogenitäten in der Schichtdicke aufweisen kann. Die Nanopartikelschicht 3 bildet hierbei eine gut haftende und defektarme Grenzschicht zwischen einem Untergrund, beispielsweise einer Pufferschicht 6, und der Badabscheidungsschicht 2 aus, wobei etwaige Unregelmäßigkeiten der Nanopartikelschicht 3, insbesondere etwaige Durchbrechungen in einer Größenordnung von bis zu einigen zehn Nanometer, zuverlässig durch die Badabscheidungsschicht 2 ausgefüllt werden können. Weiters entfällt das bei einem Sputterprozess übliche Bombardement des Untergrunds mit hochenergetischen Teilchen, welche zu Defekten führen können. Dadurch ergeben sich insgesamt gute elektrische, optische und mechanische Eigenschaften für den transparenten Frontkontakt.

Bevorzugt kann vorgesehen sein, dass der transparente Frontkontakt, insbesondere das optoelektronische Bauteil 1, in einem Rolle-zu-Rolle Prozess hergestellt wird.

Weiters kann vorgesehen sein, dass in dem Rolle-zu-Rolle Prozess ein Durchsatz größer ist als 10m/min. Dies kann insbesondere dadurch erfolgen, dass im Rolle-zu-Rolle Prozess komplett auf ein Gasphasenabscheidungsverfahren verzichtet wird.

Bevorzugt kann vorgesehen sein, dass der transparente Frontkontakt eine Transparenz höher als 80% aufweist, besonders bevorzugt eine Transparenz zwischen 80% und 90%. Als Transparenz wird insbesondere die gemittelte Transparenz im Spektralbereich von 370nm bis 720 nm angesehen.

Besonders bevorzugt kann vorgesehen sein, dass das optoelektronische Bauteil 1 eine Solarzelle mit einem Absorber 5 und einer Pufferschicht 6 ist, wobei die Nanopartikelschicht 3 an der Pufferschicht 6 unmittelbar angrenzt. Hierbei hat sich gezeigt, dass die Kombination der Nanopartikelschicht 3 mit der Badabscheidungsschicht 2 sich besonders gut für Solarzellen eignet, da diese in einem industriellen Maßstab einfach aufzubringen sind. Weiters hat sich die Struktur, insbesondere die Kornstruktur, der Kombination der Nanopartikelschicht 3 und der Badabscheidungsschicht 2 sehr vorteilhaft bezüglich den elektrischen Eigenschaften eines transparenten Frontkontaktes für eine Solarzelle herausgestellt.

Der Absorber 5 kann bevorzugt aus einem Halbleiter sein, insbesondere aus einem Halbleiter des p-Typs. Der Absorber 5 ist jener Bestandteil des optoelektronischen Bauteils 1, in welchem ein Großteil des einfallenden Lichts zur elektrischen Energieerzeugung absorbiert wird. Der Absorber 5 kann besonders bevorzugt aus Kupfer-Indium-Gallium-Diselenid CIGS, Kupfer-Zink-Zinnsulfid CZTS oder Cu₂O ausgebildet sein.

Auf dem Absorber 5 ist eine Pufferschicht 6 angeordnet. Die Pufferschicht 6 kann insbesondere zusammen mit dem Absorber 5 einen pn-Übergang ausbilden, besonders bevorzugt einen Hetero-Übergang. Die Pufferschicht 6 kann insbesondere aus CdS, In₂S₃ oder Zn(O,S) ausgebildet sein. Die Nanopartikelschicht 3 bietet hierbei gute Hafteigenschaften auf üblichen Materialien der Pufferschicht 6. Weiters hat sich gezeigt, dass die Grenzfläche zwischen der Pufferschicht 6 aus CdS, aber auch aus In₂S₃ oder Zn(O,S), und der Nanopartikelschicht 3 wenige Defekte aufweist, was für den Wirkungsgrad des optoelektronischen Bauteils 1 vorteilhaft ist.

Bevorzugt kann die Pufferschicht 6 mittels eines Badabscheidungsverfahren hergestellt werden.

Alternativ kann die Pufferschicht 6 mittels eines Gasphasenabscheidungverfahren hergestellt werden.

Die Pufferschicht 6 kann insbesondere eine Schichtdicke von 10 nm bis 50 nm aufweisen.

An einer dem transparenten Frontkontakt gegenüberliegenden Seite des Absorbers 5 kann weiters ein Rückkontakt 7 angeordnet sein. Der Rückkontakt stellt die zweite elektrische Kontaktierung des Absorbers 5 dar. Da der Rückkontakt 7 bezüglich des Lichteinfalls auf der abgewandten Seite angeordnet ist, kann der Rückkontakt 7 intransparent sein.

Der Rückkontakt 7 kann insbesondere eine Metallschicht sein, bevorzugt aus Mo.

Besonders bevorzugt kann der Rückkontakt 7 als leitende Paste ausgebildet sein, beispielsweise als Graphit-Paste. Derart kann der Rückkontakt 7 einfach in einem Rolle zu Rolle Verfahren hergestellt werden.

Das optoelektronische Bauteil 1 kann besonders bevorzugt eine Dünnschichtsolarzelle sein. Bei einer Dünnschichtsolarzelle ist der Absorber 5 als dünne Schicht mit einer Schichtdicke im µm-Bereich ausgebildet. Der Rückkontakt 7 kann insbesondere auf einem Substrat 8 aufgebracht sein. Das Substrat kann insbesondere aus Stahl, Glas oder Kunststoff sein.

In Fig. 1 ist eine erste bevorzugte Ausführungsform des optoelektronischen Bauteils 1 dargestellt, in welchem das optoelektronische Bauteil 1 als Dünnschichtsolarzelle ausgebildet ist. Hierbei kann der Rückkontakt 7 und der Absorber 5 mittels eines Gasphasenabscheidungsverfahrens, also einem Verfahren der Beschichtung aus der Gasphase wie Bedampfen oder Kathodenzerstäubung, bevorzugt mittels eines Magnetrons, hergestellt werden. Alternativ kann der Rückkontakt 7 mittels einer elektrochemischen Abscheideverfahren hergestellt werden.

Besonders bevorzugt kann vorgesehen sein, dass der Absorber 5 als Monokornmembran ausgebildet ist. Eine Solarzelle, dessen Absorber 5 als Monokornmembran ausgebildet ist, wird auch als Monokornmembran Solarzelle bezeichnet. Bei einer Monokornmembran ist der Absorber 5 in Form einer Monolage einzelner Körner 9 ausgebildet. Die Körner 9 können insbesondere einen Durchmesser von einigen µm aufweisen, insbesondere 1 µm bis 100 µm. Die Körner 9 der Monokornmembran werden mittels eines nicht leitenden Binders 10, üblicherweise ein Kunststoff, miteinander verbunden. Der als Monokornmembran ausgebildete Absorber 5 hat gegenüber einen schichtförmigen Absorber 5 den Vorteil, dass die Körner 9 in einem getrennten Verfahren in großer Zahl hergestellt, und anschließend mit einfachen Mitteln auf eine Fläche aufgebracht werden können, wodurch auf ein Gasphasenabscheidungsverfahren unmittelbar im Produktionsprozess des optoelektronischen Bauteils 1 verzichtet werden. Dadurch kann das optoelektronische Bauteil 1 in einer Produktionsstraße kontinuierlich in einem sehr wirtschaftlichen Rolle-zu-Rolle Prozess hergestellt werden. Weiters bildet die Nanopartikelschicht 3 auf dem unebenen Untergrund der Monokornmembran eine Schicht mit vergleichsweise konstanten Eigenschaften auf, während es bei Sputterschichten zu Abschattungen oder stellenweisen großen Unterschieden in der Schichtdicke oder großen Durchbrechungen kommen kann. Dadurch kann ein hoher Wirkungsgrad des optoelektronischen Bauteils 1 erreicht werden.

Gemäß einer nicht dargestellten Ausführungsform kann die Pufferschicht 6 auf der Monokornmembran abgeschieden werden.

Besonders bevorzugt kann vorgesehen sein, dass die Pufferschicht 6 direkt auf den Körnern 9 abgeschieden ist. Hierbei erfolgt die Erzeugung der Pufferschicht 6 bei der Herstellung der Körner 9 selber. Ein derart ausgebildetes optoelektronisches Bauteil 1 ist in Fig. 2 dargestellt.

Besonders bevorzugt kann vorgesehen sein, dass bei dem Nanopartikelschichtherstellungsschritt die Dispersion umfassend Nanopartikel und Lösungsmittel mit einem Tintenaufbringungsverfahren aufgebracht wird. Das Tintenaufbringungsverfahren kann insbesondere Drucken, Aufsprühen, Rakeln oder Rotationsbeschichten sein sein. Die Dispersion kann daher ähnlich wie Tinte mittels ausgereifter technologischer Verfahren direkt auf dem Untergrund gezielt aufgetragen werden.

Das Lösungsmittel der Dispersion kann insbesondere ein organisches Lösungsmittel sein, bevorzugt 2-Propanol oder Ethanol.

Die Viskosität der Dispersion kann durch das geeignete Verhältnis Nanopartikel zu Lösungsmittel sowie die Wahl des Lösungsmittels an das verwendete Tintenaufbringungsverfahren angepasst werden. Vorzugsweise ist die Viskosität der Dispersion kleiner 50 cP, insbesondere kleiner 20 cP, besonders bevorzugt kleiner 5cP.

Bevorzugt kann vorgesehen sein, dass die Nanopartikelschicht 3 vorwiegend Nanopartikel mit einem Durchmesser von 10 nm bis 15 nm umfasst. Bei unregelmäßig geformten Nanopartikel kann der Durchmesser als der Durchmesser einer Kugel mit gleichen Volumen herangezogen werden. Bei derartigen Durchmessern kann eine feinkörnige dünne Nanopartikelschicht 3 erreicht werden.

Weiters kann vorgesehen sein, dass die Nanopartikelschicht 3 vorwiegend als Einkristalle ausgebildete Nanopartikel aufweist.

Weiters kann vorgesehen sein, dass die Nanopartikelschicht 3 vor dem Badabscheidungsschritt getempert wird. Das Tempern kann bevorzugt bei 80°C bis 120°C erfolgen. Weiters kann das Tempern für einige Minuten erfolgen. Durch dieses Tempern kann die Qualität der Nanopartikelschicht 3 verbessert werden.

Besonders bevorzugt kann vorgesehen sein, dass die Nanopartikelschicht 3 und/oder die Badabscheidungsschicht 2 aus einem Metalloxid ausgebildet sind. Besonderes bevorzugt kann die Nanopartikelschicht 3 und/oder die Badabscheidungsschicht 2 aus ZnO sein. Es können aber auch andere Metalloxide als ZnO verwendet werden, sofern diese geeignet sind.

Besonders bevorzugt kann vorgesehen sein, dass die Nanopartikelschicht 3 und die Badabscheidungsschicht 2 aus demselben Grundmaterial sind. Das selbe Grundmaterial bedeutet hierbei, dass die Nanopartikelschicht 3 und die Badabscheidungsschicht 2 abgesehen von etwaigen Dotierungen aus demselben Material sind. Dadurch kann eine besonders geringe Defektdichte an der Grenzfläche zwischen Nanopartikelschicht 3 und Badabscheidungsschicht 2 erreicht werden.

Insbesondere kann vorgesehen sein, dass die Nanopartikelschicht 3 aus einem undotierten Halbleiter oder aus einem, mit einem Element gleicher Valenz dotierten Halbleiter ausgebildet ist. Mit einem Element gleicher Valenz dotiert bedeutet, dass das dotierte Element die gleiche Valenz wie ein Element des Grundmaterials aufweist, welches durch das dotierte Element ersetzt wird. Wenn das Grundmaterial aus mehreren Elementen mit unterschiedlicher Valenz besteht, was beispielsweise bei einem Metalloxid der Fall ist, kann das dotierte Element die gleiche Valenz wie eines der Elemente haben. Dadurch kann der Shuntwiderstand hoch gehalten werden, da keine zusätzlichen Ladungsträger bereitgestellt werden. Durch die Dotierung mit Elementen gleicher Valenz kann die Elektronenaffinität der Nanopartikelschicht 3 verändert werden, und dadurch an jene der Pufferschicht 6 angepasst werden. Bei einem undotierten ZnO kann eine Elektronenaffinität der Nanopartikelschicht 3 beispielweise im Wesentlichen 4,2 eV betragen. Durch das dotieren mit Mg kann die Elektronenaffinität der Nanopartikelschicht 3 auf im Wesentlichen 3,5 eV abgesenkt werden.

Bei einem Metalloxid als Grundmaterial kann ein Elemente der Dotierung mit gleicher Valenz beispielsweise Schwefel sein, welches den Sauerstoff ersetzt.

Bei ZnO als Halbleiter können die Elemente der Dotierung mit gleicher Valenz insbesondere Mg oder Cd sein.

Bevorzugt kann vorgesehen sein, dass die Badabscheidungsschicht 2 aus einem undotierten Halbleiter oder aus einem mit einem Element gleicher Valenz und/oder mit einem Donator dotierten Halbleiter ausgebildet ist. Donatoren sind Elemente mit höherer Valenz als die Elemente des Grundmaterials, wodurch zusätzliche Ladungsträger die Leitfähigkeit erhöhen.

Besonders bevorzugt kann vorgesehen sein, dass die Valenz des Donators bei der Badabscheidungsschicht 2 lediglich um eins höher ist, als die Valenz des ersetzten Elements des Grundmaterials. Bei ZnO als Halbleiter können die Elemente der Dotierung mit einer um lediglich eins höheren Valenz verglichen mit Zn insbesondere Al, Ga oder In sein.

Besonders bevorzugt kann Badabscheidungsschicht 2 aus einem Ga dotierten ZnO ausgebildet sein.

Weiters kann vorgesehen sein, dass die Badabscheidungsschicht 2 aus einem mit einem Donator dotierten Halbleiter ausgebildet ist, wobei die Valenz des Donators um mindestens zwei höher ist als die Valenz des ersetzten Elements des Grundmaterials. Derartige Donatoren können insbesondere Ta oder Mo sein, wenn ZnO das Grundmaterial ist.

Weiters kann vorgesehen sein, dass die Nanopartikelschicht 3 eine Schichtdicke von 20 nm bis 100 nm aufweist. Hierbei hat sich gezeigt, dass eine derartige Schichtdicke optimal für den Wirkungsgrad eines als Solarzelle ausgebildeten optoelektronischen Bauteils 1 ist.

Weiters kann vorgesehen sein, dass die Badabscheidungsschicht 2 eine Schichtdicke größer 100 nm aufweist. Dadurch kann die Badabscheidungsschicht 2 zuverlässig die Nanopartikelschicht 3 überdecken.

Weiters kann vorgesehen sein, dass die Badabscheidungsschicht 2 eine Schichtdicke kleiner 5 µm, insbesondere kleiner 1 µm, besonders bevorzugt kleiner 200 nm, aufweist.

Als besonders vorteilhaft hat sich gezeigt, wenn die Badabscheidungsschicht 2 eine Schichtdicke zwischen 100 nm und 200 nm aufweist.

Durch die Dicke der Badabscheidungsschicht 2 kann insbesondere der Flächenwiderstand und die Transparenz eingestellt werden.

Bei einer Ausführungsform mit einer Badabscheidungsschicht 2 aus Ga dotierten ZnO mit einer Schichtdicke von 200 nm wurde eine Transparenz der Gesamtheit aus Nanopartikelschicht 3 und Badabscheidungsschicht 2 von 85% bis 90% sowie ein Flächenwiderstand von 2 kOhm gemessen. Diese Ausführungsform weist eine sehr hohe Transparenz und eine schnell herzustellende Badabscheidungsschicht 2 auf, allerdings ist der vergleichsweise hohe Flächenwiderstand nachteilig für eine Solarzelle.

Bei einer weiteren Ausführungsform mit einer Badabscheidungsschicht 2 aus Ga dotierten ZnO mit einer Schichtdicke von 3 µm wurde eine Transparenz der Gesamtheit aus Nanopartikelschicht 3 und Badabscheidungsschicht 2 von 80% sowie ein Flächenwiderstand von lediglich 40 bis 50 Ohm gemessen. Dieser Flächenwiderstand ist geeigneter für eine Solarzelle, allerdings auf Kosten der Transparenz und der Dauer des Badabscheidungsverfahrens.

Bevorzugt kann daher weiters vorgesehen sein, dass angrenzend zu der Badabscheidungsschicht 2 eine leitende Schicht 4 angeordnet ist. Die leitende Schicht 4 kann insbesondere unmittelbar an der Badabscheidungsschicht 2 angrenzen. Weiters kann die leitende Schicht 4 an einer der Nanopartikelschicht 3 abgewandten Seite der Badabscheidungsschicht 2 angeordnet sein. Aufgrund der möglichen Durchbrechungen der Nanopartikelschicht 3 sollte der elektrische Widerstand der Badabscheidungsschicht 2 nicht zu gering sein, damit der Shuntwiderstand des optoelektronischen Bauteils 1 hoch bleibt. Durch die zusätzliche leitende Schicht 4 kann dabei der Serienwiderstand des optoelektronischen Bauteils 1 reduziert werden, selbst wenn der Flächenwiderstand der Badabscheidungsschicht 2 an sich hoch ist.

Bevorzugt kann vorgesehen sein, dass die leitende Schicht 4 eine Transparenz höher 85%, insbesondere im Wesentlichen 90%, aufweist.

Weiters kann vorgesehen sein, dass die leitende Schicht 4 einen Flächenwiderstand kleiner 30 Ohm, insbesondere kleiner 20 Ohm, besonders bevorzugt kleiner 10 Ohm, aufweist.

Besonders bevorzugt kann vorgesehen sein, dass ein Flächenwiderstand der leitenden Schicht 4 kleiner als der Flächenwiderstand der Gesamtheit aus Nanopartikelschicht 3 und Badabscheidungsschicht 2 ist. Bevorzugt kann der Flächenwiderstand der leitenden Schicht 4 kleiner als 10%, besonders bevorzugt kleiner als 1%, des Flächenwiderstandes der Gesamtheit aus Nanopartikelschicht 3 und Badabscheidungsschicht 2 sein.

Vorgesehen ist, dass angrenzend zu der Badabscheidungsschicht 2 eine leitende Schicht 4 aus einem Netz an leitfähigen und linienförmigen Nanoelementen, insbesondere metallischen Nanodrähten oder Kohlenstoffnanoröhren, angeordnet ist. Beim Verfahren ist vorgesehen, dass auf die Badabscheidungsschicht 2 eine weitere Dispersion umfassend leitfähige und linienförmige Nanoelemente, insbesondere metallische Nanodrähte oder Kohlenstoffnanoröhren, und ein weiteres Lösungsmittel aufgebracht wird, und dass die leitfähigen und linienförmigen Nanoelemente nach einem Verflüchtigen des weiteren Lösungsmittels die leitende Schicht 4 ausbilden. Dadurch ergibt sich der Vorteil, dass die leitfähige Schicht ähnlich wie die Nanopartikelschicht 3 ebenfalls mit einem flüssigkeitsbasierenden Abscheideverfahren aufgebracht werden kann, wodurch die leitende Schicht 4 ebenfalls einfach in einem Rolle-zu-Rolle Prozess hergestellt werden kann. Die weitere Dispersion kann bevorzugt in einem Tintenaufbringungsverfahren aufgebracht werden

Die metallischen Nanodrähte können insbesondere Ag-Nanodrähte sein. Ein Netz aus Ag-Nanodrähten weist einen niedrigen Flächenwiderstand bei gleichzeitig hoher Transparenz im sichtbaren Licht auf.

## Patentansprüche

1. Optoelektronisches Bauteil (1) mit einem transparenten Frontkontakt, wobei der transparente Frontkontakt eine Badabscheidungsschicht (2) und eine, an der Badabscheidungsschicht (2) unmittelbar angrenzende Nanopartikelschicht (3) aufweist, wobei die Badabscheidungsschicht (2) aus einem undotierten Halbleiter oder aus einem mit einem Element gleicher Valenz dotierten Halbleiter ausgebildet ist, **dadurch gekennzeichnet, dass** an einer der Nanopartikelschicht (3) abgewandten Seite der Badabscheidungsschicht (2) und unmittelbar angrenzend zu der Badabscheidungsschicht (2) eine leitende Schicht (4) aus einem Netz an leitfähigen und linienförmigen Nanoelementen angeordnet ist.

2. Optoelektronisches Bauteil (1) nach Anspruch 1, **dadurch gekennzeichnet, dass** die Nanopartikelschicht (3) und/oder die Badabscheidungsschicht (2) aus einem Metalloxid, insbesondere ZnO, ausgebildet sind.

3. Optoelektronisches Bauteil (1) nach Anspruch 1 oder 2, **dadurch gekennzeichnet, dass** die Nanopartikelschicht (3) aus einem undotierten Halbleiter oder aus einem, mit einem Element gleicher Valenz dotierten Halbleiter ausgebildet ist.

4. Optoelektronisches Bauteil (1) nach einem der Ansprüche 1 bis 3, **dadurch gekennzeichnet, dass** die Nanopartikelschicht (3) vorwiegend Nanopartikel mit einem Durchmesser von 10 nm bis 15 nm umfasst.

5. Optoelektronisches Bauteil (1) nach einem der Ansprüche 1 bis 4, **dadurch gekennzeichnet, dass** die Nanopartikelschicht (3) eine Schichtdicke von 20 nm bis 100 nm aufweist.

6. Optoelektronisches Bauteil (1) nach einem der Ansprüche 1 bis 5, **dadurch gekennzeichnet, dass** die Badabscheidungsschicht (2) eine Schichtdicke größer 100 nm aufweist.

7. Optoelektronisches Bauteil (1) nach einem der Ansprüche 1 bis 6, **dadurch gekennzeichnet, dass** die Badabscheidungsschicht (2) eine Schichtdicke kleiner 5 µm, insbesondere kleiner 1 µm, besonders bevorzugt kleiner 200 nm, aufweist.

8. Optoelektronisches Bauteil (1) nach einem der Ansprüche 1 bis 7, **dadurch gekennzeichnet, dass** die leitfähigen und linienförmigen Nanoelemente metallische Nanodrähte oder Kohlenstoffnanoröhren sind.

9. Optoelektronisches Bauteil (1) nach einem der Ansprüche 1 bis 8, **dadurch gekennzeichnet, dass** das optoelektronische Bauteil (1) eine Solarzelle mit einem Absorber (5) und einer Pufferschicht (6) ist, wobei die Nanopartikelschicht (3) an der Pufferschicht (6) unmittelbar angrenzt.

10. Optoelektronisches Bauteil (1) nach Anspruch 9, **dadurch gekennzeichnet, dass** der Absorber (5) als Monokornmembran ausgebildet ist.

11. Verfahren zum Herstellen eines optoelektronischen Bauteils (1), wobei zur Herstellung eines transparenten Frontkontaktes des optoelektronischen Bauteils (1) in einem Nanopartikelschichtherstellungsschritt eine Dispersion umfassend Nanopartikel und Lösungsmittel aufgetragen wird, wobei die Nanopartikel nach einem Verflüchtigen des Lösungsmittels eine Nanopartikelschicht (3) ausbilden, wobei in einem Badabscheidungsschritt auf die Nanopartikelschicht (3) mittels eines Badabscheidungsverfahrens eine Badabscheidungsschicht (2) aufgetragen wird, wobei die Badabscheidungsschicht (2) aus einem undotierten Halbleiter oder aus einem mit einem Element gleicher Valenz dotierten Halbleiter ausgebildet ist, **dadurch gekennzeichnet, dass** auf die Badabscheidungsschicht (2) eine weitere Dispersion umfassend leitfähige und linienförmige Nanoelemente und ein weiteres Lösungsmittel aufgebracht wird, wobei die leitfähigen und linienförmigen Nanoelemente nach einem Verflüchtigen des weiteren Lösungsmittels eine leitende Schicht (4) ausbilden.

12. Verfahren nach Anspruch 11, **dadurch gekennzeichnet, dass** bei dem Nanopartikelschichtherstellungsschritt die Dispersion umfassend Nanopartikel und Lösungsmittel mit einem Tintenaufbringungsverfahren aufgebracht wird.

13. Verfahren nach Anspruch 11 oder 12, **dadurch gekennzeichnet, dass** die Nanopartikelschicht (3) vor dem Badabscheidungsschritt getempert wird.

14. Verfahren nach einem der Ansprüche 11 bis 13, **dadurch gekennzeichnet, dass** die leitfähigen und linienförmigen Nanoelemente metallische Nanodrähte oder Kohlenstoffnanoröhren sind.

## Claims

1. Optoelectronic component (1) having a transparent front contact, wherein the transparent front contact has a bath deposition layer (2) and a nanoparticle layer (3) directly adjoining the bath deposition layer (2), wherein the bath deposition layer (2) is formed from an undoped semiconductor or from a semiconductor doped with an element of the same valency, **characterized in that** a conductive layer (4) consisting of a network of conductive and linear nanoelements is arranged on a side of the bath deposition layer (2) facing away from the nanoparticle layer (3) and immediately adjacent to the bath deposition layer (2).

2. Optoelectronic component (1) according to claim 1, **characterized in that** the nanoparticle layer (3) and/or the bath deposition layer (2) are formed from a metal oxide, in particular ZnO.

3. Optoelectronic component (1) according to claim 1 or 2, **characterized in that** the nanoparticle layer (3) is formed from an undoped semiconductor or from a semiconductor doped with an element of the same valency.

4. Optoelectronic component (1) according to one of claims 1 to 3, **characterized in that** the nanoparticle layer (3) predominantly comprises nanoparticles with a diameter of 10 nm to 15 nm.

5. Optoelectronic component (1) according to one of claims 1 to 4, **characterized in that** the nanoparticle layer (3) has a layer thickness of 20 nm to 100 nm.

6. Optoelectronic component (1) according to one of claims 1 to 5, **characterized in that** the bath deposition layer (2) has a layer thickness of greater than 100 nm.

7. Optoelectronic component (1) according to one of claims 1 to 6, **characterized in that** the bath deposition layer (2) has a layer thickness of less than 5 µm, in particular less than 1 µm, particularly preferably less than 200 nm.

8. Optoelectronic component (1) according to one of claims 1 to 7, **characterized in that** the conductive and linear nanoelements are metallic nanowires or carbon nanotubes.

9. Optoelectronic component (1) according to one of claims 1 to 8, **characterized in that** the optoelectronic component (1) is a solar cell with an absorber (5) and a buffer layer (6), wherein the nanoparticle layer (3) is directly adjacent to the buffer layer (6).

10. Optoelectronic component (1) according to claim 9, **characterized in that** the absorber (5) is designed as a monograin membrane.

11. Method for producing an optoelectronic component (1), wherein to produce a transparent front contact of the optoelectronic component (1), a dispersion comprising nanoparticles and solvent is applied in a nanoparticle layer production step, wherein the nanoparticles form a nanoparticle layer (3) after volatilization of the solvent, wherein a bath deposition layer (2) is applied to the nanoparticle layer (3) by means of a bath deposition process in a bath deposition step, wherein the bath deposition layer (2) is formed from an undoped semiconductor or from a semiconductor doped with an element of the same valence, **characterized in that** a further dispersion comprising conductive and linear nanoelements and a further solvent are applied to the bath deposition layer (2), wherein the conductive and linear nanoelements form a conductive layer (4) after volatilization of the further solvent.

12. Method according to claim 11, **characterized in that** in the nanoparticle layer production step, the dispersion comprising nanoparticles and solvent is applied by an ink application method.

13. Method according to claim 11 or 12, **characterized in that** the nanoparticle layer (3) is annealed before the bath deposition step.

14. Method according to one of claims 11 to 13, **characterized in that** the conductive and linear nanoelements are metallic nanowires or carbon nanotubes.

## Revendications

1. Composant optoélectronique (1) doté d'un contact frontal transparent, le contact frontal transparent présentant une couche de dépôt par bain (2) et une couche de nanoparticules (3) directement adjacente à la couche de dépôt par bain (2), la couche de dépôt par bain (2) étant constituée d'un semi-conducteur non dopé ou d'un semi-conducteur dopé avec un élément de même valence, **caractérisé en ce qu'**une couche conductrice (4) formée d'un réseau de nanoéléments conducteurs et linéaires est disposée sur un côté de la couche de dépôt par bain (2) opposé à la couche de nanoparticules (3) et de manière immédiatement adjacente à la couche de dépôt par bain (2).

2. Composant optoélectronique (1) selon la revendication 1, **caractérisé en ce que** la couche de nanoparticules (3) et/ou la couche de dépôt par bain (2) sont constituées d'un oxyde métallique, en particulier de ZnO.

3. Composant optoélectronique (1) selon la revendication 1 ou 2, **caractérisé en ce que** la couche de nanoparticules (3) est constituée d'un semi-conducteur non dopé ou d'un semi-conducteur dopé avec un élément de même valence.

4. Composant optoélectronique (1) selon l'une des revendications 1 à 3, **caractérisé en ce que** la couche de nanoparticules (3) comprend principalement des nanoparticules d'un diamètre de 10 nm à 15 nm.

5. Composant optoélectronique (1) selon l'une des revendications 1 à 4, **caractérisé en ce que** la couche de nanoparticules (3) présente une épaisseur de couche de 20 nm à 100 nm.

6. Composant optoélectronique (1) selon l'une des revendications 1 à 5, **caractérisé en ce que** la couche de dépôt par bain (2) présente une épaisseur de couche supérieure à 100 nm.

7. Composant optoélectronique (1) selon l'une des revendications 1 à 6, **caractérisé en ce que** la couche de dépôt par bain (2) présente une épaisseur de couche inférieure à 5 µm, en particulier inférieure à 1 µm, de préférence inférieure à 200 nm.

8. Composant optoélectronique (1) selon l'une des revendications 1 à 7, **caractérisé en ce que** les nanoéléments conducteurs et linéaires sont des nanofils métalliques ou des nanotubes de carbone.

9. Composant optoélectronique (1) selon l'une des revendications 1 à 8, **caractérisé en ce que** le composant optoélectronique (1) est une cellule solaire avec un absorbeur (5) et une couche tampon (6), la couche de nanoparticules (3) étant directement adjacente à la couche tampon (6).

10. Composant optoélectronique (1) selon la revendication 9, **caractérisé en ce que** l'absorbeur (5) est réalisé sous la forme d'une membrane monograin.

11. Procédé de fabrication d'un composant optoélectronique (1), dans lequel, pour fabriquer un contact frontal transparent du composant optoélectronique (1), dans une étape de fabrication de couche de nanoparticules, une dispersion comprenant des nanoparticules et un solvant est appliquée, dans lequel les nanoparticules constituent une couche de nanoparticules (3) après évaporation du solvant, dans lequel, dans une étape de dépôt par bain, une couche de dépôt par bain (2) est appliquée sur la couche de nanoparticules (3) au moyen d'un procédé de dépôt par bain, la couche de dépôt par bain (2) étant constituée d'un semi-conducteur non dopé ou d'un semi-conducteur dopé avec un élément de même valence, **caractérisé en ce qu'**une autre dispersion comprenant des nanoéléments conducteurs et linéaires et un autre solvant est appliquée sur la couche de dépôt par bain (2), les nanoéléments conducteurs et linéaires constituant une couche conductrice (4) après évaporation de l'autre solvant.

12. Procédé selon la revendication 11, **caractérisé en ce que** dans l'étape de fabrication de la couche de nanoparticules, la dispersion comprenant des nanoparticules et un solvant est appliquée par un procédé d'application d'encre.

13. Procédé selon la revendication 11 ou 12, **caractérisé en ce que** la couche de nanoparticules (3) est recuite avant l'étape de dépôt par bain.

14. Procédé selon l'une des revendications 11 à 13, **caractérisé en ce que** les nanoéléments conducteurs et linéaires sont des nanofils métalliques ou des nanotubes de carbone.
